# EUROPEAN PATENT APPLICATION

(11) **EP 4 836 613 A1**
(43) Date of publication of application: **04.11.2026**
(21) Application number: 24910631.1
(22) Date of filing: 06.12.2024
(51) Int. Cl.: H05K 7/20

(54) **LIQUID-COOLING SYSTEM**

(30) Priority: 25.12.2023 CN 202311800013
(71) Applicant: Beijing Zitiao Network Technology Co., Ltd., Beijing 100190 (CN)
(72) Inventor: TIAN, Ting, Beijing 100028 (CN); JING, Tangbo, Beijing 100028 (CN); GUI, Chenglong, Beijing 100028 (CN); SHEN, Chen, Beijing 100028 (CN); REN, Yuanlin, Beijing 100028 (CN); WANG, Jian, Beijing 100028 (CN)
(74) Representative: Marks & Clerk LLP
(86) International application number: PCT/CN2024/137384
(87) International publication number: WO 2025/139699

(57) **Abstract**

The embodiments of the present disclosure provide a liquid cooling system, including: a first negative pressure chamber capable of receiving coolant returned from a cabinet, the first negative pressure chamber being provided with a first negative pressure control pipeline capable of regulating a pressure in the first negative pressure chamber to be lower than atmospheric pressure; and a fault-tolerance control chamber connected to the first negative pressure chamber via a first connecting pipeline, the fault-tolerance control chamber being provided with a fault-tolerance control pipeline, an air guide pipeline, and a liquid discharge pipeline, the fault-tolerance control pipeline being capable of regulating an internal pressure of the fault-tolerance control chamber to be lower than the pressure in the first negative pressure chamber in a case where a height of a liquid level of the coolant in the first negative pressure chamber is higher than a first predetermined threshold, such that the coolant in the first negative pressure chamber flows into the fault-tolerance control chamber in a case where the first connecting pipeline is opened, where the coolant in the fault-tolerance control chamber is dischargeable to an exterior of the fault-tolerance control chamber via the liquid discharge pipeline in a case where the air guide pipeline and the liquid discharge pipeline are opened.

## Description

The present application claims priority to Chinese Patent Application No. 202311800013.2, filed on December 25, 2023, and entitled "LIQUID COOLING SYSTEM", which is incorporated herein by reference in its entirety.

### TECHNICAL FIELD

Embodiments of the present disclosure generally relate to the field of device cooling technology, and more specifically, to a liquid cooling system.

### BACKGROUND

Cold plate liquid cooling solutions are widely used for cooling electronic devices in a cabinet. However, when a crack occurs in a pipeline or a chamber in a cold plate system, coolant may leak through the crack, which leads to a risk of damaging the electronic devices. The coolant in a conventional cold plate system is usually under medium and high pressure operating conditions. The higher the internal pressure, the higher the risk of coolant leakage. In order to reduce the risk of coolant leakage, it is necessary to control the liquid supply pressure of a cold distribution unit (CDU), strictly manage all connection processes in the cold plate system, and install leakage detection ropes in a data center room and a server. These measures make the production, operation, and maintenance costs of the liquid cooling system relatively high, and there is still a risk of coolant leakage.

### SUMMARY

In an aspect of the present disclosure, a liquid cooling system is provided, including: a first negative pressure chamber capable of receiving coolant returned from a cabinet, the first negative pressure chamber being provided with a first negative pressure control pipeline capable of regulating a pressure in the first negative pressure chamber to be lower than atmospheric pressure; and a fault-tolerance control chamber connected to the first negative pressure chamber via a first connecting pipeline, the fault-tolerance control chamber being provided with a fault-tolerance control pipeline, an air guide pipeline, and a liquid discharge pipeline, the fault-tolerance control pipeline being capable of regulating an internal pressure of the fault-tolerance control chamber to be lower than the pressure in the first negative pressure chamber in a case where a height of a liquid level of the coolant in the first negative pressure chamber is higher than a first predetermined threshold, such that the coolant in the first negative pressure chamber flows into the fault-tolerance control chamber in a case where the first connecting pipeline is opened, where the coolant in the fault-tolerance control chamber is dischargeable to an exterior of the fault-tolerance control chamber via the liquid discharge pipeline in a case where the air guide pipeline and the liquid discharge pipeline are opened.

It should be understood that the content described in this section is neither intended to identify key or essential features of the embodiments of the present disclosure, nor is it intended to limit the scope of the present disclosure. Other features of the present disclosure will be readily envisaged through the following description.

### BRIEF DESCRIPTION OF THE DRAWINGS

The above and other features, advantages and aspects of the embodiments of the present disclosure will become more apparent in combination with the drawings and with reference to the following detailed description. In the drawings, the same or similar reference symbols refer to the same or similar elements, where:
FIG. 1 and FIG. 2 show local structural schematic diagrams of a liquid cooling system according to some embodiments of the present disclosure; and
FIG. 3 and FIG. 4 show structural schematic diagrams of a fault-tolerance control chamber according to some embodiments of the present disclosure.

### Description of reference symbols in the drawings:

100 liquid cooling system;
11 first negative pressure chamber;
110 liquid level;
111 first negative pressure control pipeline;
12 second negative pressure chamber;
121 second negative pressure control pipeline;
20 fault-tolerance control chamber;
201 first portion;
202 second portion;
211 first connecting pipeline;
212 second connecting pipeline;
22 fault-tolerance control pipeline;
23 air guide pipeline;
24 liquid discharge pipeline;
25 isolation unit;
26 liquid injection port;
31 first valve;
32 second valve;
33 third valve;
34 fourth valve;
35 fifth valve.

### DETAILED DESCRIPTION OF EMBODIMENTS

Preferred embodiments of the present disclosure will be described in more detail below with reference to the drawings. Although the preferred embodiments of the present disclosure are shown in the drawings, it should be understood that the present disclosure may be implemented in various forms and should not be limited by the embodiments set forth herein. On the contrary, these embodiments are provided for the purpose of making the present disclosure more thorough and complete, and for the purpose of conveying the scope of the present disclosure completely to those skilled in the art.

As used herein, the term "include/comprise" and its variants represent open-ended inclusions, that is, "include/comprise but not limited to". Unless otherwise stated, the term "or" represents "and/or". The term "based on" represents "at least partially based on". The terms "an example embodiment" and "an embodiment" represent "at least one example embodiment". The term "another embodiment" represents "at least one another embodiment". The terms "first", "second" and the like may refer to different or same objects.

As mentioned above, in a conventional cold plate liquid cooling system, in order to reduce the risk of coolant leakage, it is necessary to control the liquid supply pressure of a cold distribution unit, strictly manage all connection processes in the cold plate system, and install leakage detection ropes in a data center room and a server. These measures make the production, operation, and maintenance costs of the liquid cooling system relatively high, and there is still a risk of coolant leakage.

Embodiments of the present disclosure provides a liquid cooling system in which a negative pressure chamber is provided. A certain degree of vacuum may be generated in the negative pressure chamber by using a vacuum pump, so that the liquid cooling system is partially or entirely in a negative pressure environment. Since the interior of the liquid cooling system is in the negative pressure environment and the pressure therein is lower than atmospheric pressure, when a local breakage occurs in the liquid cooling system, the coolant does not leak out from the breakage. On the contrary, external air is sucked into the liquid cooling system at the breakage. The air will circulate in the form of bubbles with the coolant and reach a chamber , and be discharged out of the liquid cooling system under the degassing action of the vacuum pump. In this way, the liquid leakage caused by the local leakage may be avoided.

However, in a case where the liquid cooling system is severely damaged or multiple cabinets are disconnected from the liquid cooling system, a large amount of coolant may be sucked back into the negative pressure chamber due to the negative pressure. Generally, a lower part of the negative pressure chamber is liquid and an upper part thereof is an air chamber. When too much liquid is sucked back, a liquid level in the negative pressure chamber will rise. If the air chamber is filled up, the vacuum pump will not be able to maintain a certain degree of vacuum for the negative pressure chamber, resulting in the failure of the negative pressure environment of the liquid cooling system. This will make the whole negative pressure liquid cooling system unable to operate normally, resulting in serious failure consequences.

Since the interior of the negative pressure liquid cooling system is the negative pressure environment, when there is too much liquid in the negative pressure chamber, the liquid cannot be simply discharged through a drain valve before the vacuum degree control fails, while the pressure stabilizing system of a positive pressure liquid cooling system cannot be adopted. During the design stage, the negative pressure liquid cooling system can enhance the fault tolerance of the system in the case of leakage by expanding the volume of the negative pressure chamber. However, due to space limitations, this fault tolerance is very limited and is only limited to a relatively small-scale leakage. If there is a relatively large-scale leakage or even if only a relatively large number of servers or cabinets go offline, the fault tolerance limit will be reached, resulting in serious systematic failure.

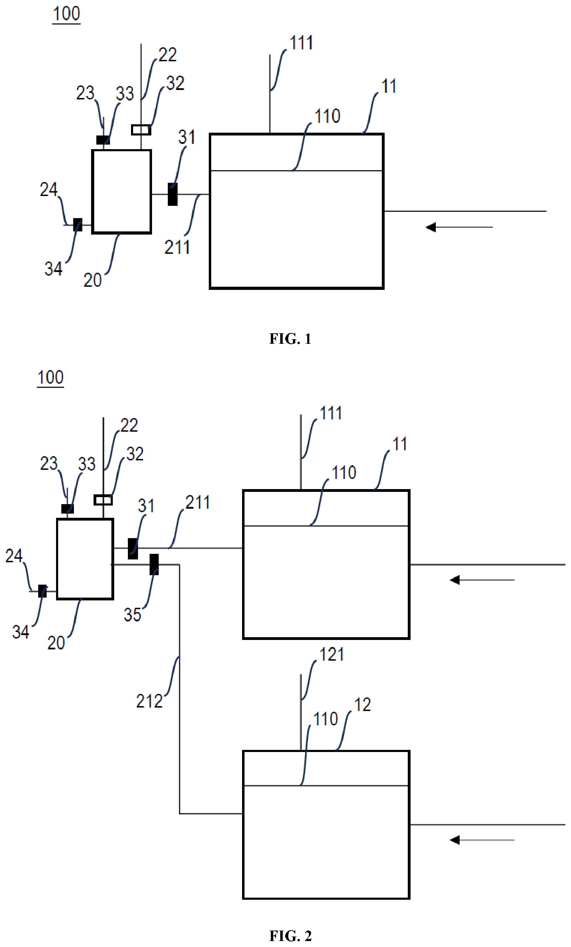

Therefore, how to design a leakage fault-tolerance structure of a negative pressure liquid cooling system to avoid the short-term failure of the negative pressure liquid cooling system caused by a high degree of damage or disconnection of multiple cabinets from the liquid cooling system is crucial for the stability of the negative pressure system, especially for the reliability of the large-scale deployed negative pressure liquid cooling system. Embodiments of the present disclosure provide a leakage fault-tolerance negative pressure liquid cooling system, in which a fault-tolerance control chamber is provided for a negative pressure chamber. When there are relatively many cabinets going offline or relatively serious damage occurring, too much coolant returned to the negative pressure chamber may flow into the fault-tolerance control chamber, and then be discharged from the fault-tolerance control chamber to the exterior of the liquid cooling system, thereby avoiding the problem of the failure of the negative pressure environment inside the liquid cooling system. The principles of the present disclosure will be described below with reference to FIG. 1 to FIG. 4.

FIG. 1 shows a local structural schematic diagram of a liquid cooling system 100 according to some embodiments of the present disclosure. As shown in FIG. 1, the liquid cooling system 100 described herein generally includes a first negative pressure chamber 11 and a fault-tolerance control chamber 20. The first negative pressure chamber 11 is connected to the fault-tolerance control chamber 20 via a first connecting pipeline 211. The first negative pressure chamber 11 is capable of receiving coolant returned from, for example, a cabinet. In embodiments of the present disclosure, the coolant may be water or any other available type, and the scope of the present disclosure is not limited in this regard. When there is too much coolant in the first negative pressure chamber 11, the excess coolant may flow into the fault-tolerance control chamber 20 via the first connecting pipeline 211, and then be discharged from the fault-tolerance control chamber 20 to the exterior of the liquid cooling system 100, thereby avoiding the problem of the failure of the negative pressure environment inside the liquid cooling system 100.

As shown in FIG. 1, the first negative pressure chamber 11 is provided with a first negative pressure control pipeline 111. The first negative pressure control pipeline 111 is capable of regulating, under the driving of a negative pressure regulating apparatus such as a vacuum pump, a pressure in the first negative pressure chamber 11 to be lower than atmospheric pressure to have a certain level of vacuum. As an example, the pressure in the first negative pressure chamber 11 may be below 50 kilopascals (kPa). It should be understood that the pressure in the first negative pressure chamber 11 may have any appropriate value lower than the atmospheric pressure, and the scope of the present disclosure is not limited in this regard.

As shown in FIG. 1, the coolant in the first negative pressure chamber 11 has a liquid level 110. There is coolant below the liquid level 110 and a gas space above the liquid level 110. During the stable operation of the liquid cooling system 100, the liquid level 110 may be basically stable or may fluctuate within a certain range. Under the driving of the negative pressure regulating apparatus, part of the gas in the gas space may be sucked out of the gas space via the first negative pressure control pipeline 111, so that the gas space has a certain degree of vacuum and forms a negative pressure environment, which makes the pressure in the first negative pressure chamber 11 lower than the atmospheric pressure.

It should be understood that in addition to the vacuum pump, the negative pressure regulating apparatus may include, for example, any known or future available regulating apparatus for creating a negative pressure environment in the first negative pressure chamber 11 via the first negative pressure control pipeline 111.

In some embodiments, as shown in FIG. 1, the fault-tolerance control chamber 20 is provided with a fault-tolerance control pipeline 22, an air guide pipeline 23, and a liquid discharge pipeline 24. The fault-tolerance control pipeline 22 is capable of regulating an internal pressure of the fault-tolerance control chamber 20 to be lower than the pressure in the first negative pressure chamber 11 in a case where a height of the liquid level 110 of the coolant in the first negative pressure chamber 11 is higher than a first predetermined threshold. The pressure difference between the first negative pressure chamber 11 and the fault-tolerance control chamber 20 will cause the coolant in the first negative pressure chamber 11 to flow into the fault-tolerance control chamber 20 in a case where the first connecting pipeline 211 is opened. When a liquid level of the coolant in the fault-tolerance control chamber 20 reaches a certain level, the first connecting pipeline 211 and the fault-tolerance control pipeline 22 may be closed, and the air guide pipeline 23 and the liquid discharge pipeline 24 may be opened. In this case, the coolant in the fault-tolerance control chamber 20 may be discharged to an exterior of the fault-tolerance control chamber 20 via the liquid discharge pipeline 24, for example, discharged into the outdoor environment.

In embodiments of the present disclosure, the first predetermined threshold may be set as needed to prevent the liquid level 110 of the coolant in the first negative pressure chamber 11 from being too high. As an example, the first predetermined threshold may be set to a predetermined proportion of a height of the first negative pressure chamber 11, for example, 65%, 70%, 75%, 80%, 85%, or a higher or lower proportions.

In some embodiments, as shown in FIG. 1, the first connecting pipeline 211 is provided with a first valve 31, the fault-tolerance control pipeline 22 is provided with a second valve 32, the air guide pipeline 23 is provided with a third valve 33, and the liquid discharge pipeline 24 is provided with a fourth valve 34. Each of the first valve 31, the second valve 32, the third valve 33, and the fourth valve 34 is capable of switching between an open state and a closed state, to enable a corresponding pipeline to switch between an open state and a closed state. In some embodiments, the first valve 31, the second valve 32, the third valve 33, and the fourth valve 34 may be electronic valves. However, it should be understood that the first valve 31, the second valve 32, the third valve 33, and the fourth valve 34 may be any known or future available valves, and embodiments of the present disclosure is not limited in this regard.

In some embodiments, as shown in FIG. 1, in a case where the height of the liquid level 110 of the coolant in the first negative pressure chamber 11 is higher than the first predetermined threshold and the internal pressure of the fault-tolerance control chamber 20 is higher than the pressure in the first negative pressure chamber 11, the second valve 32 is opened, and the first valve 31, the third valve 33, and the fourth valve 34 are closed, so that the fault-tolerance control pipeline 22 is opened, while the first connecting pipeline 211, the air guide pipeline 23, and the liquid discharge pipeline 24 are closed. In this case, a negative pressure regulating apparatus such as a vacuum pump may be used to regulate the internal pressure of the fault-tolerance control chamber 20 to be lower than the pressure in the first negative pressure chamber 11.

In some embodiments, as shown in FIG. 1, in the a where the internal pressure of the fault-tolerance control chamber 20 is regulated to be lower than the pressure in the first negative pressure chamber 11, the first valve 31 and the second valve 32 are opened, and the third valve 33 and the fourth valve 34 are closed, so that the fault-tolerance control pipeline 22 and the first connecting pipeline 211 are opened, while the air guide pipeline 23 and the liquid discharge pipeline 24 are closed. In this case, the pressure difference between the first negative pressure chamber 11 and the fault-tolerance control chamber 20 will cause the coolant in the first negative pressure chamber 11 to flow into the fault-tolerance control chamber 20 via the first connecting pipeline 211, thereby reducing the height of the liquid level 110 in the first negative pressure chamber 11.

In some embodiments, as shown in FIG. 1, in a case where the liquid level of the coolant in the fault-tolerance control chamber 20 is higher than a first predetermined liquid level, the first valve 31 and the second valve 32 are closed, and the third valve 33 and the fourth valve 34 are opened, so that the fault-tolerance control pipeline 22 and the first connecting pipeline 211 are closed, while the air guide pipeline 23 and the liquid discharge pipeline 24 are opened. In this case, the pressure inside the fault-tolerance control chamber 20 may return to the atmospheric pressure, so that the coolant in the fault-tolerance control chamber 20 may be discharged to the exterior of the fault-tolerance control chamber 20 via the liquid discharge pipeline 24, for example, discharged into the outdoor environment. The first predetermined liquid level may be set as needed. For example, the first predetermined liquid level may be set as the liquid level at which the fault-tolerance control chamber 20 is filled with coolant or is close to being filled with coolant. Certainly, the first predetermined liquid level may also be set as the liquid level at which the fault-tolerance control chamber 20 is filled with coolant to other positions, for example, filled to 70%, 75%, 80%, 85%, 90%, or higher or lower proportions.

In some embodiments, as shown in FIG. 1, in a case where the coolant in the fault-tolerance control chamber 20 is discharged to a liquid level lower than a second predetermined liquid level and the height of the liquid level 110 of the coolant in the first negative pressure chamber 11 is higher than the first predetermined threshold, the second valve 32 is opened, and the first valve 31, the third valve 33, and the fourth valve 34 are closed, so that the fault-tolerance control pipeline 22 is opened, while the first connecting pipeline 211, the air guide pipeline 23, and the liquid discharge pipeline 24 are closed. In this case, the negative pressure regulating apparatus such as a vacuum pump may be used again to regulate the internal pressure of the fault-tolerance control chamber 20 to be lower than the pressure in the first negative pressure chamber 11. Subsequently, the process described above may be repeatedly performed to discharge the coolant in the first negative pressure chamber 11 into the fault-tolerance control chamber 20 again, and then discharge the coolant in the fault-tolerance control chamber 20 to the exterior of the fault-tolerance control chamber 20.

The second predetermined liquid level is lower than the first predetermined liquid level and may be set as needed. For example, the second predetermined liquid level may be set as the liquid level in a case where the coolant in the fault-tolerance control chamber 20 is discharged completely or basically discharged completely. Certainly, the second predetermined liquid level may also be set as the liquid level at which the coolant in the fault-tolerance control chamber 20 is discharged to other positions, for example, discharged to 5%, 10%, 15%, or higher or lower proportions.

According to embodiments of the present disclosure, when there are relatively many cabinets disconnected from the liquid cooling system 100 or relatively serious damage occurs in the liquid cooling system 100, too much coolant returned to the first negative pressure chamber 11 may flow into the fault-tolerance control chamber 20, and then be discharged from the fault-tolerance control chamber 20 to the exterior of the liquid cooling system 100, thereby avoiding the failure of the vacuum degree of the first negative pressure chamber 11.

It should be understood that in addition to the first negative pressure chamber 11 and the fault-tolerance control chamber 20, the liquid cooling system 100 further includes other components and pipelines, such as a heat exchanger, a circulation pump, and a filter, etc., and the working principles of these components will not be repeated here.

FIG. 2 shows a local structural schematic diagram of a liquid cooling system 100 according to another embodiment of the present disclosure. The structure of the liquid cooling system 100 shown in FIG. 2 is similar to the structure of the liquid cooling system 100 shown in FIG. 1. In the following, only the differences between the two will be described, and the same parts will not be repeated.

In some embodiments, as shown in FIG. 2, the liquid cooling system 100 further includes a second negative pressure chamber 12, and the second negative pressure chamber 12 is capable of receiving coolant returned from the cabinet. Similar to the first negative pressure chamber 11, the second negative pressure chamber 12 is provided with a second negative pressure control pipeline 121. The second negative pressure control pipeline 121 is capable of regulating a pressure in the second negative pressure chamber 12 to be lower than the atmospheric pressure. The second negative pressure chamber 12 is connected to the fault-tolerance control chamber 20 via a second connecting pipeline 212. The second connecting pipeline 212 is provided with a fifth valve 35, and the fifth valve 35 is capable of switching between an open state and a closed state, so as to enable the second connecting pipeline 212 to switch between an open state and a closed state. With this arrangement, when the liquid level 110 of the coolant in the second negative pressure chamber 12 is too high, the fifth valve 35 may be opened to discharge the coolant in the second negative pressure chamber 12 into the fault-tolerance control chamber 20, so as to avoid the failure of the vacuum degree control of the second negative pressure chamber 12.

In some embodiments, instead of a shared fault-tolerance control chamber 20, separate fault-tolerance control chambers 20 may be provided for the first negative pressure chamber 11 and the second negative pressure chamber 12. In this case, the first negative pressure chamber 11 and the second negative pressure chamber 12 may, under the regulation of their corresponding fault-tolerance control chambers 20 respectively, avoid their respective liquid levels 110 from being too high.

In some embodiments, in addition to the first negative pressure chamber 11 and the second negative pressure chamber 12, the liquid cooling system 100 may further include a plurality of negative pressure chambers, which may be connected to the shared fault-tolerance control chamber 20 via corresponding connecting pipelines, or respectively connected to separate fault-tolerance control chambers 20.

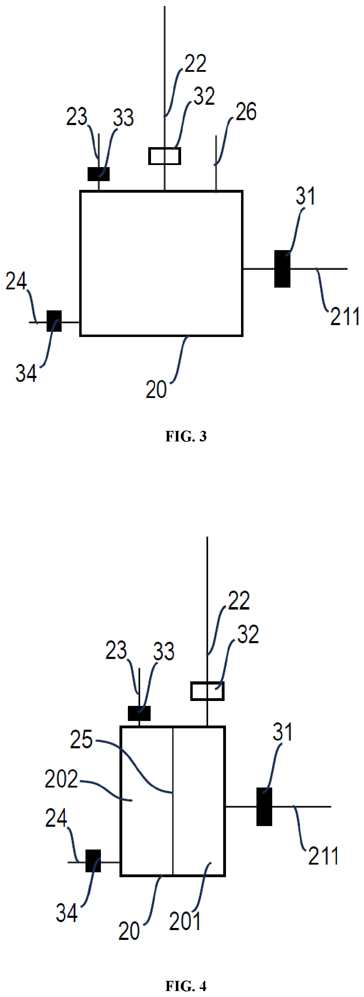

FIG. 3 shows a structural schematic diagram of a fault-tolerance control chamber 20 according to some embodiments of the present disclosure. The structure of the fault-tolerance control chamber 20 shown in FIG. 3 is similar to the structure of the fault-tolerance control chamber 20 in the liquid cooling system 100 shown in FIG. 1. In the following, only the differences between the two will be described, and the same parts will not be repeated.

In some cases, when the liquid level 110 in the first negative pressure chamber 11 is abnormally low, the fault-tolerance control chamber 20 may also be used as an active correction method for the abnormal liquid level. Specifically, the fault-tolerance control pipeline 22 is capable of regulating the internal pressure of the fault-tolerance control chamber 20 to be higher than the pressure in the first negative pressure chamber 11 in a case where the height of the liquid level 110 of the coolant in the first negative pressure chamber 11 is lower than a second predetermined threshold, so that the coolant in the fault-tolerance control chamber 20 flows into the first negative pressure chamber 11 in a case where the first connecting pipeline 211 is opened. When the liquid level 110 of the first negative pressure chamber 11 is too low, the internal pressure level of the fault-tolerance control chamber 20 may be regulated to a higher level, which is higher than the pressure in the first negative pressure chamber 11. As an example, methods such as increasing the pressure in the fault-tolerance control chamber 20 via the fault-tolerance control pipeline 22, or communicating the fault-tolerance control chamber 20 with the atmosphere may be adopted.

In embodiments of the present disclosure, the second predetermined threshold may be set as needed to prevent the liquid level 110 of the coolant in the first negative pressure chamber 11 from being too low. As an example, the second predetermined threshold may be set to a predetermined proportion of the height of the first negative pressure chamber 11, for example, 5%, 10%, 15%, 20%, or a higher or lower proportions.

In some embodiments, as shown in FIG. 3, the second valve 32 and the fourth valve 34 may be closed, while the first valve 31 and the third valve 33 may be opened, so that the first connecting pipeline 211 and the air guide pipeline 23 are opened, while the fault-tolerance control pipeline 22 and the liquid discharge pipeline 24 are closed. In this case, the fault-tolerance control chamber 20 may directly inject coolant into the first negative pressure chamber 11. In this way, it may prevent the liquid level 110 of the coolant in the first negative pressure chamber 11 from being too low.

In some embodiments, as shown in FIG. 3, the fault-tolerance control chamber 20 is further provided with a liquid injection port 26, which is used to add additional coolant into the fault-tolerance control chamber 20. The liquid injection port 26 provided on the fault-tolerance control chamber 20 is communicated with the internal negative pressure environment, so it may automatically suck in external liquid to realize fluid infusion to the liquid cooling system 100.

FIG. 4 shows a structural schematic diagram of a fault-tolerance control chamber 20 according to some embodiments of the present disclosure. The structure of the fault-tolerance control chamber 20 shown in FIG. 4 is similar to the structure of the fault-tolerance control chamber 20 in the liquid cooling system 100 shown in FIG. 1. In the following, only the differences between the two will be described, and the same parts will not be repeated.

Since the vacuum degree control and the electronic valve control have high response speeds, it is relatively easy to obtain continuous and stable control of the height of the liquid level 110 in the negative pressure chamber according to embodiments of the present disclosure. However, when the negative pressure chamber is small or the liquid level is already too high, an isolation structure may be provided in the fault-tolerance control chamber 20 to avoid the fluctuation of the liquid level 110 in the negative pressure chamber. For this purpose, in some embodiments, as shown in FIG. 4, the liquid cooling system 100 further includes an isolation unit 25, which is disposed in the fault-tolerance control chamber 20 and is capable of switching between an open state and a closed state. The isolation unit 25 divides the fault-tolerance control chamber 20 into a first portion 201 and a second portion 202 in the closed state, and the first portion 201 is connected to the first connecting pipeline 211 and the fault-tolerance control pipeline 22. The second portion 202 is connected to the air guide pipeline 23 and the liquid discharge pipeline 24.

In some embodiments, as shown in FIG. 4, the first portion 201 and the second portion 202 may be arranged left and right. In some embodiments, the first portion 201 and the second portion 202 may be arranged in other ways, for example, arranged one above the other. For example, the first portion 201 may be disposed above the second portion 202, and this arrangement may accelerate the flow of the coolant between the first portion 201 and the second portion 202.

In some embodiments, as shown in FIG. 4, in a case where the height of the liquid level 110 of the coolant in the first negative pressure chamber 11 is higher than the first predetermined threshold and the internal pressure of the fault-tolerance control chamber 20 is higher than the pressure in the first negative pressure chamber 11, the second valve 32 and the isolation unit 25 are opened, and the first valve 31, the third valve 33, and the fourth valve 34 are closed, so that the fault-tolerance control pipeline 22 is opened, the first portion 201 is communicated with the second portion 202 , while the first connecting pipeline 211, the air guide pipeline 23, and the liquid discharge pipeline 24 are closed. In this case, a negative pressure regulating apparatus such as a vacuum pump may be used to regulate the internal pressure of the fault-tolerance control chamber 20 to be lower than the pressure in the first negative pressure chamber 11.

In some embodiments, as shown in FIG. 4, in a case where the internal pressure of the fault-tolerance control chamber 20 is regulated to be lower than the pressure in the first negative pressure chamber 11, the first valve 31, the second valve 32, and the isolation unit 25 are opened, and the third valve 33 and the fourth valve 34 are closed, so that the fault-tolerance control pipeline 22 and the first connecting pipeline 211 are opened, the first portion 201 is communicated with the second portion 202, while the air guide pipeline 23 and the liquid discharge pipeline 24 are closed. In this case, the pressure difference between the first negative pressure chamber 11 and the fault-tolerance control chamber 20 will cause the coolant in the first negative pressure chamber 11 to flow into the fault-tolerance control chamber 20 via the first connecting pipeline 211, thereby reducing the height of the liquid level 110 in the first negative pressure chamber 11.

In some embodiments, as shown in FIG. 4, in a case where the liquid level of the coolant in the fault-tolerance control chamber 20 is higher than the first predetermined liquid level, the isolation unit 25 is closed, and the first valve 31, the second valve 32, the third valve 33, and the fourth valve 34 are opened, so that the first portion 201 and the second portion 202 are isolated from each other, while the fault-tolerance control pipeline 22, the first connecting pipeline 211, the air guide pipeline 23, and the liquid discharge pipeline 24 are all opened. In this case, the coolant in the second portion 202 of the fault-tolerance control chamber 20 may be discharged to the exterior of the fault-tolerance control chamber 20 via the liquid discharge pipeline 24, and at the same time, the coolant in the first negative pressure chamber 11 may continue to flow into the first portion 201 of the fault-tolerance control chamber 20.

In some embodiments, as shown in FIG. 4, in a case where the discharge of the coolant in the second portion 202 of the fault-tolerance control chamber 20 ends, the third valve 33 and the fourth valve 34 are closed, and the first valve 31, the second valve 32, and the isolation unit 25 are opened, so that the fault-tolerance control pipeline 22 and the first connecting pipeline 211 are opened, the first portion 201 is communicated with the second portion 202, while the air guide pipeline 23 and the liquid discharge pipeline 24 are closed. In this case, the coolant in the first portion 201 of the fault-tolerance control chamber 20 may flow into the second portion 202, and the coolant in the first negative pressure chamber 11 may continuously flow into the fault-tolerance control chamber 20.

By providing the isolation unit 25, the first negative pressure chamber 11 may continuously and stably deliver excess coolant to the fault-tolerance control chamber 20. When the amount of the coolant in the fault-tolerance control chamber 20 reaches a certain level, the isolation unit 25 may be closed. At this point, the second portion 202 of the fault-tolerance control chamber 20 may continuously discharge liquid, while the first portion 201 may continuously draw liquid from the first negative pressure chamber 11. When the second portion 202 finishes discharging liquid, the isolation unit 25 may be quickly opened after the third valve 33 and the fourth valve 34 are closed, so that the liquid quickly flows into the second portion 202. Then the isolation unit 25 is closed, the third valve 33 and the fourth valve 34 are reopened, and the second portion 202 continues to discharge liquid. After the coolant in the second portion 202 is discharged, the above process may be repeated. During the circulation process, the fault-tolerance control chamber 20 may continuously and stably draw liquid from the first negative pressure chamber 11.

The embodiments of the present disclosure are also embodied in the following examples.

Example 1. A liquid cooling system, including:
a first negative pressure chamber capable of receiving coolant returned from a cabinet, the first negative pressure chamber being provided with a first negative pressure control pipeline capable of regulating a pressure in the first negative pressure chamber to be lower than atmospheric pressure; and
a fault-tolerance control chamber connected to the first negative pressure chamber via a first connecting pipeline, the fault-tolerance control chamber being provided with a fault-tolerance control pipeline, an air guide pipeline, and a liquid discharge pipeline, the fault-tolerance control pipeline being capable of regulating an internal pressure of the fault-tolerance control chamber to be lower than the pressure in the first negative pressure chamber in a case where a height of a liquid level of the coolant in the first negative pressure chamber is higher than a first predetermined threshold, such that the coolant in the first negative pressure chamber flows into the fault-tolerance control chamber in a case where the first connecting pipeline is opened, where the coolant in the fault-tolerance control chamber is dischargeable to an exterior of the fault-tolerance control chamber via the liquid discharge pipeline in a case where the air guide pipeline and the liquid discharge pipeline are opened.

Example 2. The liquid cooling system of example 1, where the first connecting pipeline is provided with a first valve, the fault-tolerance control pipeline is provided with a second valve, the air guide pipeline is provided with a third valve, and the liquid discharge pipeline is provided with a fourth valve, each of the first valve, the second valve, the third valve, and the fourth valve being capable of switching between an open state and a closed state, to enable the corresponding pipeline to switch between an open state and a closed state.

Example 3. The liquid cooling system of example 2, where in a case where the height of the liquid level of the coolant in the first negative pressure chamber is higher than the first predetermined threshold and the internal pressure of the fault-tolerance control chamber is higher than the pressure in the first negative pressure chamber, the second valve is opened, and the first valve, the third valve, and the fourth valve are closed, so as to regulate the internal pressure of the fault-tolerance control chamber to be lower than the pressure in the first negative pressure chamber.

Example 4. The liquid cooling system of example 3, where in a case where the internal pressure of the fault-tolerance control chamber is regulated to be lower than the pressure in the first negative pressure chamber, the first valve and the second valve are opened, and the third valve and the fourth valve are closed, such that the coolant in the first negative pressure chamber flows into the fault-tolerance control chamber.

Example 5. The liquid cooling system of example 4, where in a case where a liquid level of the coolant in the fault-tolerance control chamber is higher than a first predetermined liquid level, the first valve and the second valve are closed, and the third valve and the fourth valve are opened, such that the coolant in the fault-tolerance control chamber is discharged to the exterior of the fault-tolerance control chamber via the liquid discharge pipeline.

Example 6. The liquid cooling system of example 5, where in a case where the coolant in the fault-tolerance control chamber is discharged to a liquid level lower than a second predetermined liquid level and the height of the liquid level of the coolant in the first negative pressure chamber is higher than the first predetermined threshold, the second valve is opened, and the first valve, the third valve, and the fourth valve are closed, to regulate the internal pressure of the fault-tolerance control chamber to be lower than the pressure in the first negative pressure chamber, where the second predetermined liquid level is lower than the first predetermined liquid level.

Example 7. The liquid cooling system of example 2, further including an isolation unit disposed in the fault-tolerance control chamber and capable of switching between an open state and a closed state, where the isolation unit divides the fault-tolerance control chamber into a first portion and a second portion in the closed state, the first portion being connected to the first connecting pipeline and the fault-tolerance control pipeline, and the second portion being connected to the air guide pipeline and the liquid discharge pipeline.

Example 8. The liquid cooling system of example 7, where in a case where the height of the liquid level of the coolant in the first negative pressure chamber is higher than the first predetermined threshold and the internal pressure of the fault-tolerance control chamber is higher than the pressure in the first negative pressure chamber, the second valve and the isolation unit are opened, and the first valve, the third valve, and the fourth valve are closed, to regulate the internal pressure of the fault-tolerance control chamber to be lower than the pressure in the first negative pressure chamber.

Example 9. The liquid cooling system of example 8, where in a case where the internal pressure of the fault-tolerance control chamber is regulated to be lower than the pressure in the first negative pressure chamber, the first valve, the second valve, and the isolation unit are opened, and the third valve and the fourth valve are closed, such that the coolant in the first negative pressure chamber flows into the fault-tolerance control chamber.

Example 10. The liquid cooling system of example 9, where in a case where a liquid level of the coolant in the fault-tolerance control chamber is higher than a first predetermined liquid level, the isolation unit is closed, and the first valve, the second valve, the third valve, and the fourth valve are opened, such that the coolant in the second portion of the fault-tolerance control chamber is discharged to the exterior of the fault-tolerance control chamber via the liquid discharge pipeline, and the coolant in the first negative pressure chamber flows into the first portion of the fault-tolerance control chamber.

Example 11. The liquid cooling system of example 10, where in a case where discharge of the coolant in the second portion of the fault-tolerance control chamber ends, the third valve and the fourth valve are closed, and the first valve, the second valve, and the isolation unit are opened, such that the coolant in the first portion of the fault-tolerance control chamber flows into the second portion, and the coolant in the first negative pressure chamber flows into the fault-tolerance control chamber.

Example 12. The liquid cooling system of example 1, where the fault-tolerance control pipeline is capable of regulating the internal pressure of the fault-tolerance control chamber to be higher than the pressure in the first negative pressure chamber in a case where the height of the liquid level of the coolant in the first negative pressure chamber is lower than a second predetermined threshold, such that the coolant in the fault-tolerance control chamber flows into the first negative pressure chamber in a case where the first connecting pipeline is opened.

Example 13. The liquid cooling system of example 12, where the fault-tolerance control chamber is further provided with a liquid injection port for adding additional coolant into the fault-tolerance control chamber.

Example 14. The liquid cooling system of example 1, further including:
a second negative pressure chamber capable of receiving coolant returned from the cabinet, the second negative pressure chamber being provided with a second negative pressure control pipeline capable of regulating a pressure in the second negative pressure chamber to be lower than the atmospheric pressure, the second negative pressure chamber being connected to the fault-tolerance control chamber via a second connecting pipeline, the second connecting pipeline being provided with a fifth valve capable of switching between an open state and a closed state, so as to enable the second connecting pipeline to switch between an open state and a closed state.

The embodiments of the present disclosure have been described above, and the above description is illustrative, non-exhaustive, and not limited to the disclosed embodiments. Many modifications and variations will be apparent to those of ordinary skill in the art without departing from the scope and spirit of the described embodiments. The choice of terms used herein is intended to best explain the principles, practical applications, or technical improvements to the market of the embodiments, or to enable other ordinary skilled persons in the art to understand the embodiments disclosed herein.

## Claims

1. A liquid cooling system (100), comprising:
a first negative pressure chamber (11) capable of receiving coolant returned from a cabinet, the first negative pressure chamber (11) being provided with a first negative pressure control pipeline (111) capable of regulating a pressure in the first negative pressure chamber (11) to be lower than atmospheric pressure; and
a fault-tolerance control chamber (20) connected to the first negative pressure chamber (11) via a first connecting pipeline (211), the fault-tolerance control chamber (20) being provided with a fault-tolerance control pipeline (22), an air guide pipeline (23), and a liquid discharge pipeline (24), the fault-tolerance control pipeline (22) being capable of regulating an internal pressure of the fault-tolerance control chamber (20) to be lower than the pressure in the first negative pressure chamber (11) in a case where a height of a liquid level (110) of the coolant in the first negative pressure chamber (11) is higher than a first predetermined threshold, such that the coolant in the first negative pressure chamber (11) flows into the fault-tolerance control chamber (20) in a case where the first connecting pipeline (211) is opened, wherein the coolant in the fault-tolerance control chamber (20) is dischargeable to an exterior of the fault-tolerance control chamber (20) via the liquid discharge pipeline (24) in a case where the air guide pipeline (23) and the liquid discharge pipeline (24) are opened.

2. The liquid cooling system (100) of claim 1, wherein the first connecting pipeline (211) is provided with a first valve (31), the fault-tolerance control pipeline (22) is provided with a second valve (32), the air guide pipeline (23) is provided with a third valve (33), and the liquid discharge pipeline (24) is provided with a fourth valve (34), each of the first valve (31), the second valve (32), the third valve (33), and the fourth valve (34) being capable of switching between an open state and a closed state, to enable a corresponding pipeline to switch between an open state and a closed state.

3. The liquid cooling system (100) of claim 2, wherein in a case where the height of the liquid level (110) of the coolant in the first negative pressure chamber (11) is higher than the first predetermined threshold and the internal pressure of the fault-tolerance control chamber (20) is higher than the pressure in the first negative pressure chamber (11), the second valve (32) is opened, and the first valve (31), the third valve (33), and the fourth valve (34) are closed, so as to regulate the internal pressure of the fault-tolerance control chamber (20) to be lower than the pressure in the first negative pressure chamber (11).

4. The liquid cooling system (100) of claim 3, wherein in a case where the internal pressure of the fault-tolerance control chamber (20) is regulated to be lower than the pressure in the first negative pressure chamber (11), the first valve (31) and the second valve (32) are opened, and the third valve (33) and the fourth valve (34) are closed, such that the coolant in the first negative pressure chamber (11) flows into the fault-tolerance control chamber (20).

5. The liquid cooling system (100) of claim 4, wherein in a case where a liquid level of the coolant in the fault-tolerance control chamber (20) is higher than a first predetermined liquid level, the first valve (31) and the second valve (32) are closed, and the third valve (33) and the fourth valve (34) are opened, such that the coolant in the fault-tolerance control chamber (20) is discharged to the exterior of the fault-tolerance control chamber (20) via the liquid discharge pipeline (24).

6. The liquid cooling system (100) of claim 5, wherein in a case where the coolant in the fault-tolerance control chamber (20) is discharged to a liquid level lower than a second predetermined liquid level and the height of the liquid level (110) of the coolant in the first negative pressure chamber (11) is higher than the first predetermined threshold, the second valve (32) is opened, and the first valve (31), the third valve (33), and the fourth valve (34) are closed, to regulate the internal pressure of the fault-tolerance control chamber (20) to be lower than the pressure in the first negative pressure chamber (11), wherein the second predetermined liquid level is lower than the first predetermined liquid level.

7. The liquid cooling system (100) of claim 2, further comprising an isolation unit (25) disposed in the fault-tolerance control chamber (20) and capable of switching between an open state and a closed state, wherein the isolation unit (25) divides the fault-tolerance control chamber (20) into a first portion (201) and a second portion (202) in the closed state, the first portion (201) being connected to the first connecting pipeline (211) and the fault-tolerance control pipeline (22), and the second portion (202) being connected to the air guide pipeline (23) and the liquid discharge pipeline (24).

8. The liquid cooling system (100) of claim 7, wherein in a case where the height of the liquid level (110) of the coolant in the first negative pressure chamber (11) is higher than the first predetermined threshold and the internal pressure of the fault-tolerance control chamber (20) is higher than the pressure in the first negative pressure chamber (11), the second valve (32) and the isolation unit (25) are opened, and the first valve (31), the third valve (33), and the fourth valve (34) are closed, to regulate the internal pressure of the fault-tolerance control chamber (20) to be lower than the pressure in the first negative pressure chamber (11).

9. The liquid cooling system (100) of claim 8, wherein in a case where the internal pressure of the fault-tolerance control chamber (20) is regulated to be lower than the pressure in the first negative pressure chamber (11), the first valve (31), the second valve (32), and the isolation unit (25) are opened, and the third valve (33) and the fourth valve (34) are closed, such that the coolant in the first negative pressure chamber (11) flows into the fault-tolerance control chamber (20).

10. The liquid cooling system (100) of claim 9, wherein in a case where a liquid level of the coolant in the fault-tolerance control chamber (20) is higher than a first predetermined liquid level, the isolation unit (25) is closed, and the first valve (31), the second valve (32), the third valve (33), and the fourth valve (34) are opened, such that the coolant in the second portion (202) of the fault-tolerance control chamber (20) is discharged to the exterior of the fault-tolerance control chamber (20) via the liquid discharge pipeline (24), and the coolant in the first negative pressure chamber (11) flows into the first portion (201) of the fault-tolerance control chamber (20).

11. The liquid cooling system (100) of claim 10, wherein in a case where discharge of the coolant in the second portion (202) of the fault-tolerance control chamber (20) ends, the third valve (33) and the fourth valve (34) are closed, and the first valve (31), the second valve (32), and the isolation unit (25) are opened, such that the coolant in the first portion (201) of the fault-tolerance control chamber (20) flows into the second portion (202), and the coolant in the first negative pressure chamber (11) flows into the fault-tolerance control chamber (20).

12. The liquid cooling system (100) of claim 1, wherein the fault-tolerance control pipeline (22) is capable of regulating the internal pressure of the fault-tolerance control chamber (20) to be higher than the pressure in the first negative pressure chamber (11) in a case where the height of the liquid level (110) of the coolant in the first negative pressure chamber (11) is lower than a second predetermined threshold, such that the coolant in the fault-tolerance control chamber (20) flows into the first negative pressure chamber (11) in a case where the first connecting pipeline (211) is opened.

13. The liquid cooling system (100) of claim 12, wherein the fault-tolerance control chamber (20) is further provided with a liquid injection port (26) for adding additional coolant to the fault-tolerance control chamber (20).

14. The liquid cooling system (100) of claim 1, further comprising:
a second negative pressure chamber (12) capable of receiving coolant returned from the cabinet, the second negative pressure chamber (12) being provided with a second negative pressure control pipeline (121) capable of regulating a pressure in the second negative pressure chamber (12) to be lower than the atmospheric pressure, the second negative pressure chamber (12) being connected to the fault-tolerance control chamber (20) via a second connecting pipeline (212), the second connecting pipeline (212) being provided with a fifth valve (35) capable of switching between an open state and a closed state, so as to enable the second connecting pipeline (212) to switch between an open state and a closed state.
